# EUROPEAN PATENT SPECIFICATION

(11) **EP 0 508 618 B1**
(45) Date of publication and mention of the grant of the patent: **24.09.1997**
(21) Application number: 92302306.3
(22) Date of filing: 18.03.1992
(51) Int. Cl.: H01L 21/285, H01L 29/40, H01L 33/00

(54) **Method of making ohmic contact to a III-V semiconductor device**
Methode zur Herstellung eines ohmschen Kontaktes auf einer Halbleitervorrichtung
Méthode de fabrication d'un contact ohmique sur un dispositif semiconducteur

(30) Priority: 26.03.1991 US 675304
(43) Date of publication of application: 14.10.1992
(73) Proprietor: AT&T Corp., New York, NY 10013-2412 (US)
(72) Inventor: Dautremont-Smith, William Crossley, Westfield, New Jersey 07090 (US); Katz, Avishay, Westfield, New Jersey 07090 (US); Koszi, Louis Alex, Scotch Plains, New Jersey 07076 (US); Segner, Bryan Phillip, Piscataway, New Jersey 08854 (US); Thomas, Peter McLean, Murray Hill, New Jersey 07974 (US)
(74) Representative: Watts, Christopher Malcolm Kelway, Dr.

(56) References cited:
- EP-A- 0 386 775
- EP-A- 0 413 491
- PATENT ABSTRACTS OF JAPAN vol. 12, no. 330 (E-655)7 September 1988
- JOURNAL OF THE ELECTROCHEMICAL SOCIETY vol. 127, no. 5, May 1980, MANCHESTER, NEW HAMPSHIRE US pages 1202 - 1205 D.V.MORGAN ET AL. 'Rectifying and ohmic contacts to GaInAsP'
- JOURNAL OF APPLIED PHYSICS. vol. 66, no. 5, 1 September 1989, NEW YORK US pages 2056 - 2060 A.KATZ ET AL. 'AuBe/p-InGaAsP contact formed by rapid thermal processing'
- JOURNAL OF APPLIED PHYSICS. vol. 68, no. 3, 1 August 1990, NEW YORK US pages 1123 - 1128 A.KATZ ET AL. 'Au/Pt/Ti contacts to p-InGaAs and n-InP layers formed by a single metallization common step and rapid thermal processing'
- JOURNAL OF APPLIED PHYSICS. vol. 67, no. 7, 1 April 1990, NEW YORK US pages 3323 - 3327 K.CHANG ET AL. 'Lattice-mismatched InGaAs/InAlAs modulation-doped field-effect transistors on GaAs: Molecular-beam epitaxial growth and device performance'
- SOLAR CELLS vol. 27, no. 1-4, December 1989, LAUSANNE CH pages 177 - 189 M.A. NICOLET ET AL. 'Issues in metal/semiconductor contact design and implementation'

## Description

### Field of the Invention

This invention pertains to methods of making semiconductor devices. More particularly, it pertains to methods of making semiconductor devices based on III-V material, exemplarily InP-based photonic and electronic devices, e.g., lasers, LEDs and transistors.

### Background of the Invention

The need for making a non-rectifying (ohmic) contact to a semiconductor body exists throughout the semiconductor field. In the field of III/V-based semiconductors it has been conventional to use so-called alloyed contacts. For a review of the relevant prior art see applicants' U.S. patent No. 5,036,023, which discloses an advantageous method of making III/V semiconductor devices.

In particular, the '023 patent discloses depositing p-side Ti/Pt and n-side Ti/Pt onto the relevant surfaces of a semiconductor body, followed by an appropriate heat treatment that results in simultaneous formation of p-side and n-side ohmic contacts. See also A. Katz et al., J. Appl. Physics. Vol 66 (5), p. 2056 (Sept. '89) and EP-A-0 413 491, which report substantially the same subject matter as US-A- 5 036 023.

JP-A-63095661 discloses a InGaAsP substrate of undisclosed conductivity type with a Au/Ti/Pt/Au layer structure thereon.

Although the method of the '023 patent is a substantial advance over conventional methods, it would still be desirable to have available a method that can result in higher device yields and/or device lifetime. This application discloses such a method.

### Brief Description of the Drawing

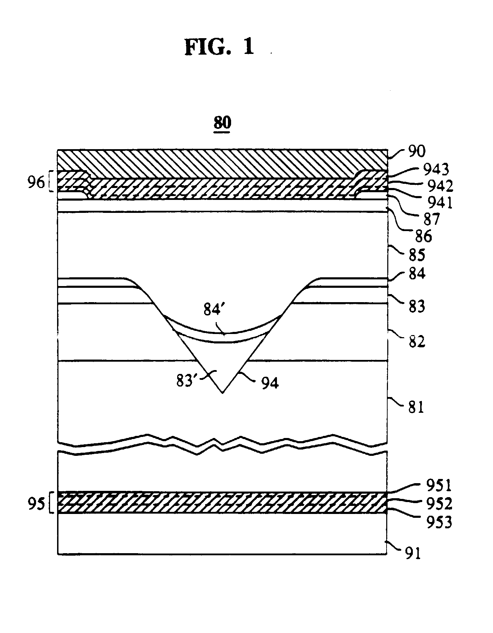

FIG. 1 schematically depicts an exemplary device made according to the invention.

### The invention

The invention is as defined by the claims. The invention is a method of making an article that comprises a semiconductor device, exemplarily a semiconductor laser, optical amplifier, or light emitting diode. The method comprises providing a semiconductor body that comprises a p-doped first semiconductor material and an n-doped second semiconductor material. At least the first semiconductor material comprises as major constituents both indium and arsenic. The first and second semiconductor materials form a first and a second surface, respectively, of the semiconductor body. The method further comprises depositing first contact material onto the first surface, heat treating the semiconductor body with the contact material thereon, and carrying out one or more steps towards completion of the article.

Significantly, the first contact material-depositing step comprises depositing, in sequence, a first intermediate layer that comprises Au (and typically also comprises Be), a first conductor layer that comprises Ti, and a second conductor layer that comprises Pt. The method further comprises depositing, prior to said heat treating step, second contact material onto the second surface, the second contact material comprising third and fourth conductor layers that comprise Ti and Pt, respectively, with the fourth conductor layer being disposed on the third conductor layer. Still furthermore, the heat treating step comprises a "rapid thermal processing" (RTP) step that comprises heating the semiconductor body with the contact material thereon to a temperature in the range 400-500°C for a time in the range 10-100 seconds, such that ohmic contacts to the first and second semiconductor materials are formed simultaneously.

Currently preferred temperatures and times for processing InP-based devices are in the ranges 425 -475°C and 15-60 seconds, respectively. Appropriate choice of RTP parameters can result in low specific contact resistance,exemplarily 10⁻⁷ Ω · cm² or even lower, for the p-side contact on InGaAs.

Optionally the inventive process comprises depositing a second intermediate layer (typically comprising Au and Ge) on the second semiconductor surface, followed by deposition of the third and fourth conductor layers. In at least some embodiments the semiconductor body with the first intermediate layer thereon is subjected to a heat treatment (exemplarily RTP) prior to deposition of the other layers.

The inventive method also comprises a variety of conventional steps, exemplarily including epitaxial deposition of semiconductor layers on a semiconductor substrate, oxide deposition, photolithography, wet and/or dry etching, Au deposition, dicing or cleaving of a semiconductor wafer, AR-coating and mirror deposition, solder bonding and/or wire bonding, and device testing and packaging. Such processing steps require no detailed discussion.

Although the invention is not so limited, the discussion below will be primarily in terms of devices wherein the first and second surfaces are on opposite sides of the semiconductor body, as is the case in conventional semiconductor lasers and LEDs. In "single side" devices the first and second surfaces are on the same side of the semiconductor body, and the inventive method can be particularly advantageously used to produce such devices as well as III-V-based transistors, as will be apparent to those skilled in the art.

A significant aspect of the invention is the presence of In and As in at least the first semiconductor material. Typically this material is the "contact layer" of the p-terminal of an inventive device. Exemplarily the contact layer is In₁₋ₓGaₓAs, with x typically in the range 0. 0.1-0.9, exemplarily 0.47. The presence of both In and As at the metal/semiconductor interface is thought to result in a relatively low Schottky barrier, and thus make possible a contact having a low specific contact resistance.

In the practice of the inventive method, the semiconductor body can be prepared in conventional manner, and this preparation thus does not require detailed discussion. Furthermore, many of the process steps can be as described in the '023 patent. This pertains, for instance, to the heat treatment after deposition of both contact material layers.

In embodiments of the inventive process the first and/or third conductor layers are not deposited directly onto the first and/or second semiconductor surfaces but instead are deposited onto a previously deposited Au-containing thin (typically <100 nm) intermediate layer. We have discovered that use of such an intermediate layer in one or both of the contacts frequently results in increased device yield and/or lifetime.

Exemplarily, the p-side contact comprises a 5-80 nm thick AuBe intermediate layer, and the n-side contact comprises a 7-20 nm thick AuGe intermediate layer. Techniques for depositing AuBe and AuGe layers are well known in the art. Exemplarily, all of the layers of both the first and second contact material can be deposited by means of electron beam evaporation.

Although embodiments of the inventive method comprise an RTP step subsequent to the deposition of all the conductor layers, some embodiments may comprise an optional heat treatment step (typically also RTP) prior to deposition of any of the conductor layers but subsequent to deposition of the first intermediate layer.

FIG. 1 schematically depicts an exemplary device according to the invention, namely a channeled substrate buried heterostructure (CSBH) laser diode 80. The laser comprises n-InP substrate 81, semi-insulating Fe-doped InP layer 82, n-InP buffer layer 83 and 83', InGaAsP layer 84 and 84' (active layer), p-InP cladding layer 85, and p⁺ InGaAs layer 86. The laser further comprises patterned SiO₂ layer 87 defining the p-contact region. Numerals 95 and 96 refer to the first and second contact material, respectively. Each contact material layer comprises an intermediate layer (941 and 951), Ti layer (942 or 952), and Pt layer (943 or 953). Gold layers 90 and 91 complete the p- and n-contact, respectively.

Example: A CSBH laser chip as shown in FIG. 1 is produced substantially as follows.

On a (100)-oriented 275 µm thick, n-InP (10¹⁸ cm⁻³ sulfur doped) substrate is grown an epitaxial semi-insulating Fe-doped (resistance greater than 10⁶ Ω cm) 2 µm thick InP layer by conventional organometallic vapor phase epitaxy (OMVPE). After treating the surface in a manner substantially as described in US patent 4, 595, 454, a 0.3 µm thick SiO₂ layer is formed by plasma deposition, and 2 µm wide stripe windows opened in the SiO₂ layer by conventional photolithography and etching. Next, V-grooves are formed also substantially as described in US patent 4, 595, 454, and the patterned SiO₂ layer is removed by conventional wet etching. A double heterostructure, consisting of a 1 µm thick n-InP layer, an InGaAsP layer that is lattice matched to the InP and has a bandgap of 1.3 µm, a p-InP layer, and a p⁺ InGaAs layer, is then grown by conventional liquid phase epitaxy (LPE) on the grooved surface of the wafer. After completion of the LPE growth, the p-contacts are formed. In particular, a 300 nm thick layer of SiO₂ is formed on the p-side surface by plasma deposition, and stripes, overlying the V-grooves, are opened in the SiO₂ layer by conventional photolithography and etching. Subsequently, a 20 nm thick AuBe layer is deposited, followed by an RTP treatment. Next, a 50 nm thick Ti layer, followed by a 75 nm thick Pt layer, are deposited by e-gun evaporation, followed by removal of unwanted contact material by conventional lift-off. The wafer is then thinned to about 80 µm by conventional lapping and wet etching. This is followed by formation of the n-contacts, including a 12 nm thick AuGe intermediate layer, in the same manner the p-contacts have been formed previously. Next the wafer is subjected to a RTP treatment, by heating in a forming gas (15% b.v. H₂) atmosphere to 440°C for 30 seconds. This is followed by photolithography and conventional electrodeposition of a 0.8 µm thick gold layer on each of the n- and p-sides of the wafer, to form the n- and p-contact pads, respectively. Next the wafer is scribed and cleaved to form chips with high-quality laser mirror facets, and the thus produced laser chips are tested by conventional means. The metal layers form ohmic contacts, with the p-contacts having a specific contact resistance of less than 10⁻⁷ Ω · cm². The thus produced lasers typically perform as expected, and show good long-term stability.

## Claims

1. A method of making an article comprising a semiconductor device, the method comprising
a) providing a semiconductor body (80) that comprises a p-doped first semiconductor material (86) comprising both In and As, and that further comprises a n-doped second semiconductor material (81), the first and second semiconductor materials forming a first and a second surface of the body, respectively;
b) depositing first contact material (96) onto the first surface and second contact material (95) onto the second surface, with both first and second contact materials comprising, in sequence, a Ti-containing layer (942, 952) and a Pt-containing layer (943, 953);
c) heat treating the semiconductor body with the first and second contact materials thereon, the heat treatment comprising heating the semiconductor body with the contact materials thereon to a temperature in the range 400-500°C for a time in the range 10-100 seconds, such that ohmic contacts to the first and second semiconductor materials are formed simultaneously; and
d) completing making the article;
CHARACTERIZED IN THAT step b) comprises depositing, prior to deposition of the Ti-containing layer (942), a Au-containing layer (941) onto the first surface.

2. The method of claim 1, wherein step b) further comprises depositing a Au-containing layer (951) onto the second surface prior to deposition of the Ti-containing layer (952).

3. The method of claim 1, additionally comprising heat treating the body with the Au-containing layer (941) on the first surface prior to deposition of the Ti-containing layer (942) thereon.

4. The method of claim 3, wherein said additional heat treating prior to deposition of the Ti-containing layer comprises heating the semiconductor body to a temperature in the range 400-500°C for a time in the range 10-100 seconds.

5. The method of claim 2, wherein the Au-containing layer (941) on the first surface consists essentially of Au and Be, the Au-containing layer (951) on the second surface consists essentially of Au and Ge, and the Ti-containing and Pt-containing layers consist essentially of Ti and Pt, respectively.

6. The method of claim 2, further comprising depositing a Au-containing layer (90, 91) onto each of the Pt-containing layers.

## Patentansprüche

1. Verfahren zur Herstellung eines Gegenstandes mit einer Halbleitereinrichtung, wobei das Verfahren umfaßt
a) Bereitstellen eines Halbleiterkörpers (80), der ein erstes p-dotiertes Halbleitermaterial (86) enthält, welches In und As enthält und welches ferner ein n-dotiertes zweites Halbleitermaterial (81) enthält, wobei das erste und das zweite Halbleitermaterial eine erste bzw. eine zweite Oberfläche des Körpers bilden,
b) Abscheiden von erstem Kontaktmaterial (96) an der ersten Oberfläche und von zweitem Kontaktmaterial (95) an der zweiten Oberfläche, wobei beide, das erste und das zweite Kontaktmaterial in Folge eine Ti-enthaltende Schicht (942, 952) und eine Pt-enthaltende Schicht (943, 953) enthalten,
c) Wärmebehandeln des Halbleiterkörpers mit dem ersten und dem zweiten Kontaktmaterial an diesem, wobei die Wärmebehandlung das Erhitzen des Halbleiterkörpers mit den Kontaktmaterialien an diesem auf eine Temperatur in dem Bereich von 400 - 500°C während einer Zeitdauer im Bereich von 10 - 100 Sekunden enthält derart, daß Ohm'sche Kontakte zu dem ersten und dem zweiten Halbleitermaterial gleichzeitig ausgebildet werden und
d) Vervollständigung der Herstellung des Gegenstandes, dadurch gekennzeichnet, daß Schritt b) das Abscheiden einer Au-enthaltenden Schicht (941) an der ersten Oberfläche vor dem Abscheiden der Ti-enthaltenden Schicht (942) umfaßt.

2. Verfahren nach Anspruch 1, bei welchem Schritt b) ferner das Abscheiden einer Au-enthaltenden Schicht (951) an der zweiten Oberfläche vor dem Abscheiden der Ti-enthaltenden Schicht (952) umfaßt.

3. Verfahren nach Anspruch 1, zusätzlich umfassend die Wärmebehandlung des Körpers mit der Au-enthaltenden Schicht (941) an der ersten Oberfläche vor dem Abscheiden der Ti-enthaltenden Schicht (942) an diesem.

4. Verfahren nach Anspruch 3, bei welchem die zusätzliche Wärmebehandlung vor der Abscheidung der Ti-enthaltenden Schicht das Erhitzen des Halbleiterkörpers auf eine Temperatur in dem Bereich von 400 - 500°C während einer Zeitdauer im Bereich von 10 - 100 Sekunden umfaßt.

5. Verfahren nach Anspruch 2, bei welchem die Au-enthaltende Schicht (941) an der ersten Oberfläche im wesentlichen aus Au und Be besteht, wobei die Au-enthaltende Schicht (951) an der zweiten Oberfläche im wesentlichen aus Au und Ge besteht und die Ti-enthaltenden und Pt-enthaltenden Schichten im wesentlichen aus Ti bzw. Pt bestehen.

6. Verfahren nach Anspruch 2, ferner umfassend das Abscheiden einer Au-enthaltenden Schicht (90, 91) an jeder der Pt-enthaltenden Schichten.

## Revendications

1. Procédé de fabrication d'un dispositif à semi-conducteur, le dispositif consistant :
a) à prendre un corps semi-conducteur (80), qui comprend un premier matériau semi-conducteur (86) à dopage p, comprenant à la fois de l'ln et de l'As, et qui comprend en outre un deuxième matériau semi-conducteur (81) à dopage n, le premier et le deuxième matériaux semi-conducteurs formant respectivement une première et une deuxième surfaces du corps ;
b) à déposer un premier matériau de contact (96) sur la première surface et un deuxième matériau de contact (95) sur la deuxième surface, le premier et le deuxième matériaux de contact comprenant, dans l'ordre, une couche contenant du Ti (942, 952) et une couche contenant du Pt (943, 953);
c) à soumettre à un traitement thermique le corps semi-conducteur, sur lequel sont déposées le premier et le deuxième matériaux de contact, le traitement thermique consistant à porter le corps semi-conducteur, sur lequel sont déposés les matériaux de contact, à une température comprise entre 400 et 500°C pendant un laps de temps compris entre 10 et 100 secondes, de façon à former simultanément des contacts ohmiques avec le premier et avec le deuxième matériaux semi-conducteurs ; et
d) à achever la fabrication de l'objet ;
caractérisé en ce que l'étape b) consiste à déposer sur la première surface, avant déposition de la couche (942) contenant du Ti, une couche (941) contenant de l'Au.

2. Procédé selon la revendication 1, dans lequel l'étape b) consiste en outre à déposer une couche (951) contenant de l'Au sur la deuxième surface avant déposition de la couche (952) contenant du Ti.

3. Procédé selon la revendication 1, qui consiste en outre à soumettre à un traitement thermique le corps ayant la couche (941) contenant de l'Au sur la première surface, avant d'y déposer la couche (942) contenant du Ti.

4. Procédé selon la revendication 3, dans lequel ledit traitement thermique supplémentaire avant déposition de la couche contenant du Ti consiste à porter le corps semi-conducteur à une température comprise entre 400 et 500°C pendant un laps de temps de 10 à 100 secondes.

5. Procédé selon la revendication 2, dans lequel la couche (941) contenant de l'Au se trouvant sur la première surface est constituée essentiellement d'Au et de Be, la couche (951) contenant de l'Au se trouvant sur la deuxième surface est constituée essentiellement d'Au et de Ge, et la couche contenant du Ti et la couche contenant du Pt sont essentiellement constituées respectivement de Ti et de Pt.

6. Procédé selon la revendication 2, qui consiste en outre à déposer sur chacune des couches contenant du Pt une couche (90, 91) contenant de l'Au.
